# EUROPÄISCHE PATENTSCHRIFT

(11) **EP 1 256 163 B1**
(45) Veröffentlichungstag und Bekanntmachung des Hinweises auf die Patenterteilung: **30.06.2010**
(21) Anmeldenummer: 01919118.8
(22) Anmeldetag: 26.01.2001
(51) Int. Cl.: H02M 7/00

(54) **GLEICHRICHTERANORDNUNG**
RECTIFIER SYSTEM
SYSTEME DE REDRESSEMENT

(30) Priorität: 05.02.2000 DE 10005183
(43) Veröffentlichungstag der Anmeldung: 13.11.2002
(73) Patentinhaber: ROBERT BOSCH GMBH, 70442 Stuttgart (DE)
(72) Erfinder: SPITZ, Richard, 72766 Reutlingen (DE)
(86) Internationale Anmeldenummer: PCT/DE2001/000310
(87) Internationale Veröffentlichungsnummer: WO 2001/058001

(56) Entgegenhaltungen:
- EP-A- 0 282 025
- CH-A- 661 151
- US-A- 3 241 031

## Beschreibung

### Stand der Technik

Die Erfindung geht aus von einer Gleichrichteranordnung nach der Gattung des Hauptanspruchs. Es ist schon eine solche Gleichrichteranordnung aus der deutschen Patentanmeldung DE 199 08 697 bekannt, in der jedoch keine Sicherungsmaßnahmen gegen Verpolung beschrieben sind.

Aus der Druckschrift EP-A-0 282 025 sind Halbleiteranordnungen mit Halbleiter-Gleichrichterelementen zur Gleichrichtung einer anliegenden elektrischen Wechselgröße bekannt, die zusätzlich eine Sicherung aufweisen. Die Sicherung ist dabei als eigenes Bauteil aus gegenüber den Halbleiteranordnungen unterschiedlichem Material gefertigt. Weitere Gleichrichteranordnungen mit Halbleiter Gleichrichterelementen sind aus den Druckschriften CH 661 151 A und US-A-3 241 031 bekannt.

### Vorteile der Erfindung

Die erfindungsgemäße Gleichrichteranordnung mit einer Schmelzsicherung gemäß Anspruch 1 hat demgegenüber den Vorteil, daß es ermöglicht wird, frühzeitig den Stromkreis, insbesondere im Falle einer Verpolung, zu unterbrechen und somit einen Brand, ausgelöst durch Überhitzung der Gleichrichterelemente, zu verhindern. Die hierfür vorgesehene Schmelzsicherung weist in vorteilhafter Weise die im Bereich hoher Ströme (100 A) notwendigen engen Herstelltoleranzen auf, so daß während des Normalbetriebs des Generators keine Gefahr der Auslösung des Sicherungsmechanismus besteht.

Vorteilhafte Weiterbildungen und Verbesserungen ergeben sich durch die in den abhängigen Ansprüchen und in der Beschreibung genannten Merkmale.

### Zeichnung

Ausführungsbeispiele der Erfindung sind in der Zeichnung dargestellt und in der nachfolgenden Beschreibung näher erläutert. Es zeigen Figur 1 eine Gleichrichteranordnung, Figur 2 den Halbleiterchip einer Schmelzsicherung, Figur 3 ein Kühlblech, Figur 4 die Kontaktierung einer Schmelzsicherung.

### Beschreibung der Ausführungsbeispiele

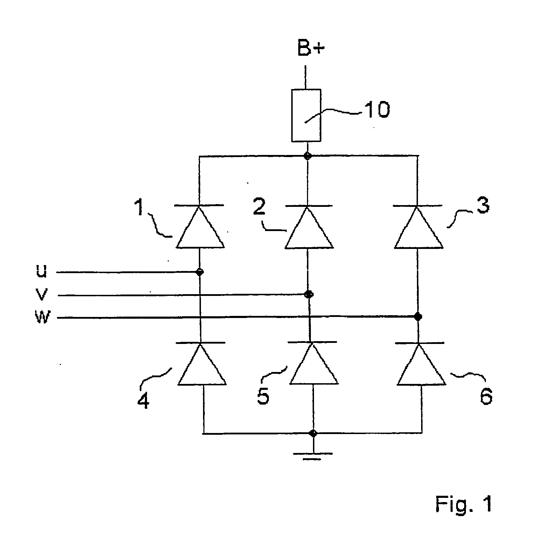

Figur 1 zeigt eine Gleichrichteranordnung für einen Drehstromgenerator in einem Kraftfahrzeug. Der Eingang mit den drei Phasenanschlüssen u, v und w ist dabei in an sich bekannter Weise mit sechs Halbleiter-Gleichrichterelementen 1 bis 6, insbesondere Halbleiterdioden, verbunden. Die Anoden der Dioden 4, 5 und 6 sind an einem einem Masseanschluß angeschlossen. Die Kathoden der Dioden 1, 2 und 3 sind ebenfalls miteinander verbunden. Sie sind über eine Schmelzsicherung 10 an dem Ausgang B+ der Gleichrichteranordnung angeschlossen.

Der Drehstrom eines Drehstromgenerator, dessen drei Phasenanschlüsse mit dem Eingang u,v,w verbunden sind, wird durch den durch die Dioden 1 bis 6 gebildeten Brückengleichrichter gleichgerichtet. Der Ausgang B+ ist mit dem Pluspol der Bordbatterie verbindbar, der Minuspol mit Masse, so daß der gleichgerichtete Strom des Drehstromgenerators die Bordbatterie aufladen kann. Die Entladung der Batterie wird durch die Dioden des Gleichrichters verhindert. Werden jedoch die Pole der Batterie vertauscht angeschlossen (zum Beispiel im Falle einer Starthilfe), kann sich die Batterie über die so in Flußrichtung geschalteten drei Diodenstrecken 1,4 beziehungsweise 2,5 beziehungsweise 3,6 entladen. Je nach Größe der Batterie und Ladezustand können Entladeströme bis zu 900 A entstehen. Um diese Entladeströme zu vermeiden, die über 60 Sekunden andauern könnten, bis durch Zerstörung der Gleichrichterdioden oder Abschmelzen von Zuleitungsdrähten der Stromkreis unterbrochen würde, ist die Schmelzsicherung 10 vorgesehen. So werden Gefahrensituationen vermieden, bei denen es zu hohen Temperaturen in den Gleichrichterkomponenten und zur Entzündung von Isolationskunststoffen kommen kann, die zum Teil mit offener Flamme brennen und Fahrzeugbrände auslösen können. Die Schmelzsicherung ist hierbei eine Sicherung auf Siliziumbasis, also dem gleichen Material, aus dem auch die Gleichrichterelemente aufgebaut sind.

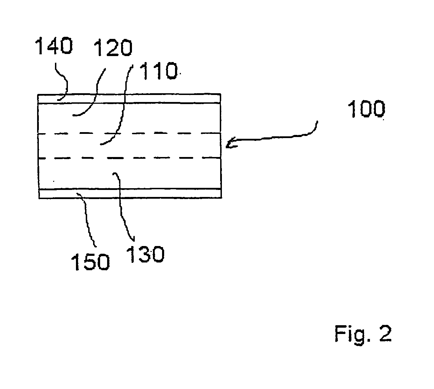

Figur 2 zeigt den Halbleiterchip 100 der Schmelzsicherung 10. Dieser Halbleiterchip weist eine n-dotierte Mittelzone 110 auf, wobei die Dotierung der Grunddotierung des bei der Herstellung verwendeten Halbleiterwafers entspricht. Die Randbereiche 120 und 130 des Chips sind stark n-dotiert und über an ihren Außenflächen aufgebrachte Metallisierungen 140 beziehungsweise 150 kontaktierbar.

Der Chip wird in ein Gehäuse eingelötet, das auch bei den Dioden des Gleichrichters eingesetzt wird. Die Vorgehensweise ist genau die gleiche wie die beispielsweise aus der DE 19549202 (R.29710) bei den Gleichrichterdioden bekannte. Der Chip wird hierbei mit Lot auf einem Einpreßsockel befestigt, und auf der anderen Seite des Chips wird der Kopfdraht aufgelötet. Der Chip hat eine Querschnittsfläche senkrecht zur Stromrichtung, die ungefähr gleich groß ist wie die entsprechende Querschnittsfläche einer Gleichrichterdiode. Dadurch erreicht man, daß der Wärmewidestand zwischen Chip und Gehäuseboden dem entsprechenden Wärmewiderstand der Gleichrichterdioden gleicht.

In einer einfacheren Ausführungsform können die hochdotierten Zonen 120 und 130 weggelassen werden und der Schmelzsicherungschip 100 vollständig aus einem n-dotierten Gebiet 110 bestehen.

Der Schmelzsicherungschip wird aus einem homogen beispielsweise mit Phosphor dotierten Siliziumwafer hergestellt, der eine Dicke zwischen 130 und 200 Mikrometern aufweist. Die Dotierstoffkonzentration beträgt 10¹⁸ cm⁻³, der spezifische Widerstand bei 25 Grad Celsius zirka 23 mΩcm. Dieser wird zur Herstellung der einfachen Ausführungsform ohne weitere Dotierschritte auf beiden Seiten mit einer Metallisierung versehen und in quadratische Einzelchips mit einer Seitenlänge von zirka 4,5 Millimetern zerteilt. Das ergibt eine Querschnittsfläche von zirka 20 Quadratmillimetern, die sich für Generatorströme über 120 A eignet. Die Beschichtung mit Metall kann zum Beispiel durch Aufsputtern von Chrom, nachfolgend Nickel-Vanadium und zuletzt Silber erfolgen. Das Zerteilen erfolgt vorzugsweise mit einer Diamantsäge. Soll der Widerstand des Schmelzsicherungschips abgesenkt werden, so ist der in Figur 2 gezeigte Aufbau zielführend. Hier muß vor der Aufbringung der Metallisierung eine weitere Dotierung des bereits dotierten Wafers und ein Diffusionsschritt erfolgen, um die hochdotierten n-Gebiete 120 und 130 zu erzeugen.

Während die Flußspannung einer Diode einen negativen Temperaturkoeffizienten aufweist, ist der Temperaturkoeffizient des homogen dotierten Schmelzsicherungschips positiv. Der Widerstand des Schmelzsicherungschips kann daher so eingestellt werden, daß im Normalbetrieb des Gleichrichters der Widerstand und damit die elektrische Verlustleistung vergleichbar ist mit der elektrischen Verlustleistung einer Gleichrichterdiode. Im Falle einer Verpolung steigt der Widerstand der Sicherung wegen des positiven Temperaturkoeffizienten stark an. Die ansteigende Temperatur lötet den Schmelzsicherungschip aus dem Gehäuse aus und der Stromkreis ist bereits nach kurzer Entladezeit der Batterie unterbrochen. Der Widerstand der Sicherung ist in engen Toleranzen einstellbar, die elektrische Verlustleistung ist durch die Dotierung und Geometrie an die Verlustleistung der Gleichrichterdioden angepaßt. Auch die Kühlung ist durch Verwendung des gleichen Gehäuses vergleichbar. Die Sicherung wird so im Falle einer Batterieverpolung stets vor den Gleichrichterdioden auslöten.

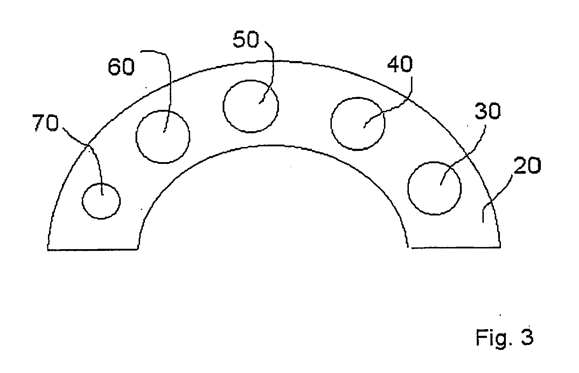

Die Figur 3 zeigt in Draufsicht ein Kühlblech 20 mit Aussparungen 30, 40, 50, 60 und 70. Die Aussparungen 20, 30 40, 50 und 60 haben den gleichen Durchmesser.

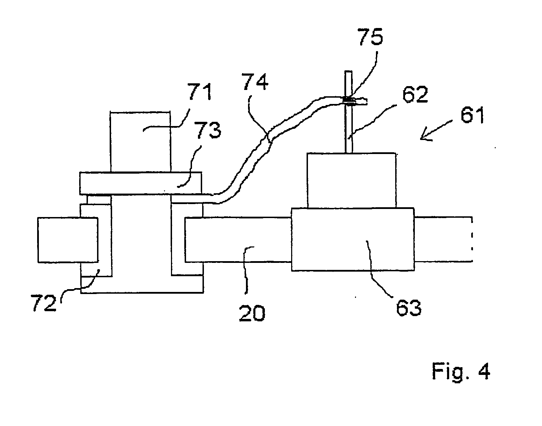

In die Aussparungen 30 bis 50 werden zur Herstellung der Gleichrichteranordnung in an sich bekannter Weise die in Form von Einpreßdioden hergestellten Gleichrichterdioden 1, 2 und 3 eingepreßt. In gleicher Weise wird das zu den Gehäusen der Gleichrichterchips identische Gehäuse des Schmelzsicherungschips in die Aussparung 60 eingepreßt. Die Aussparung 70 dient zur Anbringung einer Kontaktierung des Schmelzsicherungschips. Diese Kontaktierung ist nachfolgend in der Erläuterung der Figur 4 beschrieben.

Figur 4 zeigt einen Ausschnitt des Kühlblechs 20 mit einer in die Aussparung 60 eingepreßte Einpreßschmelzsicherung 61, also einem Einpreßgehäuse, wie es auch für die Gleichrichterdioden verwendet wird, in das aber statt eines Diodenchips ein Schmelzsicherungschip montiert ist. Die Sicherung 61 befindet sich dabei mit ihrem Einpreßsockel 63 in der Aussparung 60 des Kühlblechs. In die Aussparung 70 ist eine Kontaktschraube 71 eingebracht, die mittels einer Isolation 72 elektrisch vom Kühlblech isoliert ist. Mittels einer Kontaktmutter 73 ist ein Kontaktdraht 74 festgeklemmt, der über eine Lötstelle 75 mit dem Kopfdraht 62 der Schmelzsicherung 61 elektrisch verbunden ist.

Die Kontaktschraube 71 stellt den Ausgang B+ der Gleichrichteranordnung dar. Der Strom fließt über das Kühlblech 20, das die elektrische Verbindung der Kathoden der Dioden 1, 2 und 3 bildet, über den Einpreßsockel 63 in die Sicherung und von dort über den Kopfdraht 62, den Kontaktdraht 74 und die Kontaktschraube 71 in das Bordnetz beziehungsweise in die Batterie des Kraftfahrzeugs. Der Wärmewiderstand zwischen dem Boden der einzelnen Gehäuse der Dioden (nicht dargestellt) beziehungsweise der Sicherung 61 ist identisch. Dioden und Schmelzsicherung haben gleiche Kühlungsbedingungen. Der Gesamtwärmewiderstand zwischen Chip (also Diodenchip bzw. Schmelzsicherungschip) und Kühlluft liegt bei einer Drehzahl des Drehstromgenerators von 3000 U/min. beispielsweise bei etwa 2K/W. Bei einem Schmelzsicherungschip ohne hochdotierte Gebiete 120, 130 aus einem n-dotierten Siliziumwafer mit einem spezifischen Widerstand von 23 mΩcm bei einer Temperatur von 25 Grad Celsius, einer Chipdicke von 200 Mikrometern und einer Chipfläche von 20,3 Quadratmillimetern stellt sich bei der beschriebenen Kühlblechanordnung beispielsweise bei einem Normalbetrieb mit 120 A Generatorstrom und 120 Grad Celsius Kühllufttemperatur so eine Gleichgewichtstemperatur von 215 Grad Celsius am Schmelzsicherungschip ein. Der Spannungsabfall beträgt zirka 0,4 Volt, die elektrische Verlustleistung zirka 48 Watt. Im Vergleich dazu liegt die Chiptemperatur der Gleichrichterdioden bei 182 Grad Celsius, die Gesamtverlustleistung der drei Dioden 1, 2 und 3 bei 108 Watt. Werden Chips mit einer kleineren Dicke beispielsweise von zirka 130 Mikrometern eingesetzt, können die elektrischen Verlustleistungen weiter gesenkt werden. Die Gleichgewichtstemperatur am Schmelzsicherungschip liegt dann bei 177 Grad Celsius, der Spannungsabfall bei 0,24 Volt und die Verlustleistung bei 28 Watt (also zirka 25 Prozent der in etwa von der Chipdicke unabhängigen gleichbleibenden Verlustleistung der drei Dioden 1,2 und 3 von 108 Watt.)

## Patentansprüche

1. Gleichrichteranordnung mit Halbleiter-Gleichrichterelementen (1, 2, 3, 4, 5, 6) die von einem Gehäuse umgebene Gleichrichter-Halbleiterchips aufweisen und zur Gleichrichtung einer an einem Eingang (u, v, w) der Gleichrichteranordnung anliegenden elektrischen Wechselgröße dienen und einem Ausgang (B+) zum Abgreifen der gleichgerichteten elektrischen Größe und einer Sicherung zwischen den Halbleiter-Gleichrichterelementen (1, 2, 3, 4, 5, 6) und dem Ausgang (B+), **dadurch gekennzeichnet, dass** die Sicherung eine Schmelzsicherung (10) ist und die Schmelzsicherung (10, 61) einen durch Stromfluss aufheizbaren Halbleiterchip (100) aus dem gleichen Halbleitermaterial wie die Gleichrichterelemente (1, 2, 3, 4, 5, 6) aber mit positiven Temperaturkoeffizienten umfasst der von einem Gehäuse umgeben ist, das im wesentlichen gleich aufgebaut ist wie die Gehäuse der Halbleiter-Gleichrichterelemente. wobei dessen Lotverbindungen zu äußeren Kontaktierungen (62, 63) bei Überschreiten einer maximalen Strombelastung an mindestens einer Stelle durchschmilzt, so dass der Stromfluss durch den Halbleiterchip (10, 61) irreversibel unterbrochen wird.

2. Gleichrichteranordnung nach Anspruch 1, **dadurch gekennzeichnet, dass** der Halbleiterchip (100) der Schmelzsicherung (10, 61) senkrecht zur Stromrichtung die gleiche Querschnittsfläche aufweist wie ein Gleichrichter-Halbleiterchip.

3. Gleichrichteranordnung nach Anspruch 1 oder 2, **dadurch gekennzeichnet, dass** die Gehäuse der Gleichrichterelemente (1, 2, 3, 4, 5, 6) und der Schmelzsicherung (10, 61) Einpresssockel aufweisen und dass sowohl die Gleichrichterelemente (1, 2, 3, 4, 5, 6) als auch die Schmelzsicherung (10, 61) in gleicher Weise in ein Kühlblech eingepresst sind.

4. Gleichrichteranordnung nach Anspruch 3, **dadurch gekennzeichnet, dass** die Gleichrichterelemente (1, 2, 3, 4, 5, 6) als Brückengleichrichter verschaltet sind und dass die Schmelzsicherung (10, 61) in das gleiche Kühlblech eingepresst ist wie die die positiven Anteile der elektrischen Wechselgröße durchlassenden Halbleiter-Gleichrichterelemente (1, 2, 3).

5. Gleichrichteranordnung nach einem der vorhergehenden Ansprüche, **dadurch gekennzeichnet, dass** der Halbleiterchip (100) der Schmelzsicherung (10, 61) eine n⁺/n/n⁺ - Schichtenfolge aufweist, wobei die Schichtdicken der drei Schichten (110, 120, 130) etwa gleich groß sind.

## Claims

1. Rectifier arrangement comprising semiconductor rectifier elements (1, 2, 3, 4, 5, 6) which have rectifier semiconductor chips surrounded by a housing and serve for rectifying an alternating electrical quantity present at an input (u, v, w) of the rectifier arrangement, and an output (B+) for tapping off the rectified electrical quantity and a fuse between the semiconductor rectifier elements (1, 2, 3, 4, 5, 6) and the output (B+), **characterized in that** the fuse is a fusible link (10) and the fusible link (10, 61) comprises a semiconductor chip (100) which can be heated by current flow and is composed of the same semiconductor material as the rectifier elements (1, 2, 3, 4, 5, 6) but with a positive temperature coefficient, said semiconductor chip being surrounded by a housing constructed substantially identically to the housing of the semiconductor rectifier elements, the solder connections of said chip to external contact-connections (62, 63) melting through at at least one location when a maximum current loading is exceeded, with the result that the current flow through the semiconductor chip (10, 61) is irreversibly interrupted.

2. Rectifier arrangement according to Claim 1, **characterized in that** the semiconductor chip (100) of the fusible link (10, 61) has, perpendicularly to the current direction, the same cross-sectional area as a rectifier semiconductor chip.

3. Rectifier arrangement according to Claim 1 or 2, **characterized in that** the housings of the rectifier elements (1, 2, 3, 4, 5, 6) and of the fusible link (10, 61) have press-fit bases, and **in that** both the rectifier elements (1, 2, 3, 4, 5, 6) and the fusible link (10, 61) are press-fitted into a cooling plate in the same way.

4. Rectifier arrangement according to Claim 3, **characterized in that** the rectifier elements (1, 2, 3, 4, 5, 6) are connected up as a bridge rectifier, and **in that** the fusible link (10, 61) is press-fitted into the same cooling plate as the semiconductor rectifier elements (1, 2, 3) that transmit the positive components of the alternating electrical quantity.

5. Rectifier arrangement according to any of the preceding claims, **characterized in that** the semiconductor chip (100) of the fusible link (10, 61) has an n⁺/n/n⁺ layer sequence, the layer thicknesses of the three layers (110, 120, 130) being approximately identical in magnitude.

## Revendications

1. Système redresseur doté d'éléments redresseurs semi-conducteurs (1, 2, 3, 4, 5, 6) qui présentent une puce semi-conductrice de redresseur entourée par un boîtier et qui servent à redresser une grandeur électrique alternative appliquée sur une entrée (u, v, w) du système redresseur et
une sortie (B+) de prélèvement de la grandeur électrique redressée ainsi qu'une protection entre les éléments redresseurs semi-conducteurs (1, 2, 3, 4, 5, 6) et la sortie (B+),
**caractérisé en ce que**
la protection est une protection fusible (10),
**en ce que** la protection fusible (10, 61) comporte une puce semi-conductrice (100) apte à être chauffée par l'écoulement du courant et en le même matériau semi-conducteur que les éléments redresseurs semi-conducteurs (1, 2, 3, 4, 5, 6) mais avec un coefficient de température positif et entourée par un boîtier de structure essentiellement identique à celle du boîtier des éléments redresseurs semi-conducteurs,
**en ce que** les liaisons brasées avec les contacts extérieurs (62, 63) fondent lorsqu'une charge maximale en courant est dépassée en au moins un emplacement de telle sorte que l'écoulement de courant à travers la puce semi-conductrice (10, 61) soit interrompu de manière irréversible.

2. Système redresseur selon la revendication 1, **caractérisé en ce que** perpendiculairement à la direction d'écoulement du courant, la section transversale de la puce semi-conductrice (100) de la protection fusible (10, 61) a la même superficie qu'une puce semi-conductrice du redresseur.

3. Système redresseur selon les revendications 1 ou 2, **caractérisé en ce que** le boîtier des éléments redresseurs semi-conducteurs (1, 2, 3, 4, 5, 6) et de la protection fusible (10, 61) présentent un socle de compression et **en ce que** tant les éléments redresseurs semi-conducteurs (1, 2, 3, 4, 5, 6) que la protection fusible (10, 61) sont repoussés de même manière dans une tôle de refroidissement.

4. Système redresseur selon la revendication 3, **caractérisé en ce que** les éléments redresseurs semi-conducteurs (1, 2, 3, 4, 5, 6) sont branchés en redresseur en pont et **en ce que** la protection fusible (10, 61) est repoussée dans la même tôle de refroidissement que les éléments redresseurs semi-conducteurs (1, 2, 3) qui laissent passer les parties positives de la grandeur électrique alternative.

5. Système redresseur selon l'une des revendications précédentes, **caractérisé en ce que** la puce semi-conductrice (100) de la protection fusible (10, 61) présente une succession de couches n+/n/n+ et **en ce que** les trois couches (110, 120, 130) ont sensiblement la même épaisseur.
